# EUROPÄISCHE PATENTSCHRIFT

(11) **EP 0 538 642 B1**
(45) Veröffentlichungstag und Bekanntmachung des Hinweises auf die Patenterteilung: **07.06.1995**
(21) Anmeldenummer: 92116409.1
(22) Anmeldetag: 24.09.1992
(51) Int. Cl.: B23Q 3/157, B23Q 17/22

(54) **Verfahren zum Einspannen der Bohr- oder Fräswerkzeuge einer Leiterplatten-Bohrmaschine mit einer definierten freien Werkzeuglänge in der mit einer Spannzange versehenen Bohrspindel derselben**
Process for clamping, with a defined free working length, a drilling or milling tool of a circuit board drilling machine in the collet equipped drilling spindle of that machine
Procédé pour l'abloquage, avec une longueur libre déterminée, d'un foret ou d'une fraise d'une perçeuse à circuits imprimés dans la broche équipée d'une pince étau de cette machine

(30) Priorität: 21.10.1991 DE 4134732
(43) Veröffentlichungstag der Anmeldung: 28.04.1993
(73) Patentinhaber: KLG Electronic Gesellschaft mbH, D-87600 Kaufbeuren (DE)
(72) Erfinder: Seitz, Helmut, W-8950 Kaufbeuren (DE)
(74) Vertreter: Ruschke, Hans Edvard, Dipl.-Ing.

(56) Entgegenhaltungen:
- EP-A- 0 181 178
- EP-A- 0 287 071
- DE-A- 1 477 578
- DE-A- 3 615 888
- GB-A- 2 192 144
- US-A- 4 658 494
- US-A- 4 715 108
- US-A- 5 068 958
- PATENT ABSTRACTS OF JAPAN vol. 12, no. 1 (M-656)(2848) 6. Januar 1988

## Beschreibung

Die vorliegende Erfindung betrifft ein Verfahren zum Einspannen des Bohr- oder Fräswerkzeuges einer Leiterplatten-Bohrmaschine mit einer definierten freien Werkzeuglänge in der mit einer Spannzange versehenen Bohrspindel derselben, nach dem Oberbegriff des Patentanspruches 1.

In der EP-287 071 A2 der Anmelderin ist eine Werkzeugwechseleinrichtung für eine Leiterplatten-Bohrmaschine beschrieben, bei der eine Reihe von Bohr- und Fräswerkzeugen in einem Speichermagazin am Rande des Werkstückaufspanntisches der Leiterplatten-Bohrmaschine in Halterungen oder Buchsen achsparallel zur Bohrspindel eingesetzt sind. Zur Festlegung einer definierten Einschubtiefe bzw. zur Einschubtiefenbegrenzung für das jeweilige Werkzeug in der Bohrspindel ist der Halteschaft eines jeden Werkzeuges mit einem Anschlagring versehen, was in aller Regel durch Aufschieben eines Klemmringes auf den Schaft des Werkzeuges geschieht. Zur Entnahme eines solchen Werkzeuges aus dem Magazin fährt die leere Spannzange der Bohrspindel über das ausgewählte Werkzeug ein, so daß Spannzange und ausgewähltes Werkzeug miteinander fluchten, worauf die Spannzange der Bohrspindel so weit nach unten gefahren wird, daß der Werkzeugschaft im Bereich seines oberen Endes von der Spannzange der Spindel erfaßt wird, so daß das Werkzeug aus dem Magazin herausgezogen werden kann. Anschließend fährt die Bohrspindel mit dem in der Spannzange derselben vorläufig gehaltenen Werkzeugschaft in eine sogenannte Spannstation in der Nähe des Magazins axial ein, wobei sich eine Relativverschiebung zwischen dem Werkzeugschaft und der Spannzange der Bohrspindel ergibt, bis der Anschlagring an der unteren Stirnfläche der Spannzange der Bohrspindel zur Anlage kommt dergestalt, daß eine definierte freie Werkzeuglänge in Abhängigkeit von der Position des Anschlagringes aus der Bohrspindel herausragt - vorausgesetzt der Anschlagring hat einen definierten Abstand von der Spitze des Bohr- bzw. Fräswerkzeuges.

Neben dem Aufwand für das Aufschieben eines solchen Klemmringes auf jeden einzelnen Werkzeugschaft ergeben sich mitunter auch Probleme durch ungenaue Montage oder Verkantungen des Klemmringes, die zu Funktionsstörungen bei der Bearbeitung führen können. Außerdem nutzen sich derartige Anschlagringe u.U. ab, was zu Ungenauigkeiten bei der Bearbeitung des Werkstückes führen kann. Vor allem stellt aber die mechanische Aufbringung und die erforderliche genaue Positionierung des Anschlagringes auf den sehr zahlreichen Werkzeugen, wie sie bei üblichen Leiterplattenbohrmaschinen gebraucht werden, ein ökonomisches Problem dar.

Im GbM 88 16 298 wird ein "ringloses" Werkzeugwechselsystem gezeigt, welches in erster Linie für Leiterplatten-Bohrmaschinen gedacht ist und bei dem die einzelnen Werkzeuge mit ihrem ringlosen Halteschaft von unten in eine Magazin-Speicherplatte eingesetzt sind derart, daß das obere Ende des jeweiligen Halteschaftes der Werkzeuge an eine Anschlagplatte anstößt. Zum Werkzeugwechsel fährt ein Greifer von unten über das in der Magazin-Speicherplatte sitzende Werkzeug und ergreift es aufgrund der Anlage des Halteschaftes an der Anschlagplatte in einem genau definierten Abstand von dem oberen Ende des Werkzeuges, welches dann aus der Magazin-Speicherplatte nach unten herausgezogen und anschließend seitlich bis in eine Position in axialer Ausrichtung mit der eigentlichen Bohrspindel verfahren wird, wo das Werkzeug von unten in die Spannzange der Bohrspindel eingesetzt wird, was auch ohne die oben diskutierten Klemmringe zu einer genau definierten Einspannlänge des Werkzeuges in der Bohrspindel führt. Allerdings ist diese Anordnung konstruktiv aufwendig, weil ein separater Greifer zum Entnehmen der Werkzeuge aus der Magazin-Speicherplatte und zum Überführen des entnommenen Werkzeuges an die Bohrmaschinenspindel erforderlich ist. Außerdem führt die definierte Einspannlänge des Werkzeuges zumindest nicht direkt zur Kenntnis der wirksamen freien Länge des Bohrwerkzeuges, was aber für eine NC-gesteuerte Leiterplatten-Bohrmaschine von größter Wichtigkeit ist.

Hiernach ist es die der vorliegenden Erfindung zugrundeliegende Aufgabe, ein Verfahren anzugeben, mit dem ringlose Werkzeuge im Rahmen einer NC-gesteuerten Leiterplatten-Bohrmaschine problemlos eingesetzt werden können, ohne daß es Schwierigkeiten bzw. Unsicherheiten in Bezug auf die damit zu erreichende Bohrtiefe gibt.

Ein Verfahren zur Lösung dieser Aufgabe ergibt sich aus Anspruch 1. Hierdurch wird erreicht, daß auch bei ringlosen Werkzeugen diese immer mit einer genau definierten freien Werkzeuglänge in der Spannzange der Bohrspindel stecken, so daß stets eine genaue Korrelation zwischen dem Z-Achsenvorschub der Bohrspindel und der Tiefe der mit dem eingespannten Werkzeug erzeugten Bohrung/Fräsung gegeben ist.

Vorzugsweise wird nach Anspruch 2 der Vorschub der Bohrspindel kurzfristig unterbrochen, sobald die Spitze des Werkzeuges einen definierten Abstand größer/gleich Null von der Meßschranke erreicht hat, um Zeit für das Lösen der Spannzange der Bohrspindel und das Spannen der Spannzange der Spannstation zu gewinnen. Dadurch ergibt sich letztlich ein präziseres Einspannen des Werkzeuges in der Bohrspindel mit einer genauer reproduzierbaren freien Werkzeuglänge.

Vorzugsweise fährt die Bohrspindel das fertig eingespannte Werkzeug zunächst aus dem Meßschrankenbereich der Spannstation heraus, um anschließend nochmals einwärts in den Meßschrankenbereich einzufahren, um so den tatsächlichen Ist-Wert der freien Werkzeuglänge zu bestimmen. Auf diese Weise kann eine Abweichung vom Soll-Wert der freien Werkzeuglänge festgestellt werden, wobei entweder das erfindungsgemäße Verfahren wiederholt wird, um eine bessere Einspannung und damit eine genauere freie Werkzeuglänge zu erhalten, oder es wird von der Bohrmaschinensteuerung eine Korrekturrechnung zur Bestimmung eines korrigierten Bohrspindelvorschubes beim Bohren der Leiterplatte durchgeführt, um trotz der vom Soll-Wert der freien Werkzeuglänge abweichenden Einspannung des Werkzeuges auf die jeweils gewünschte Bohrtiefe bei der Bearbeitung der Leiterplatten zu kommen.

Das erfindungsgemäße Verfahren kann mittels einer bekannten Werkzeugwechselanordnung für Leiterplatten-Koordinatenbohrmaschinen etwa nach der EP 287 071 A2 durchgeführt werden.

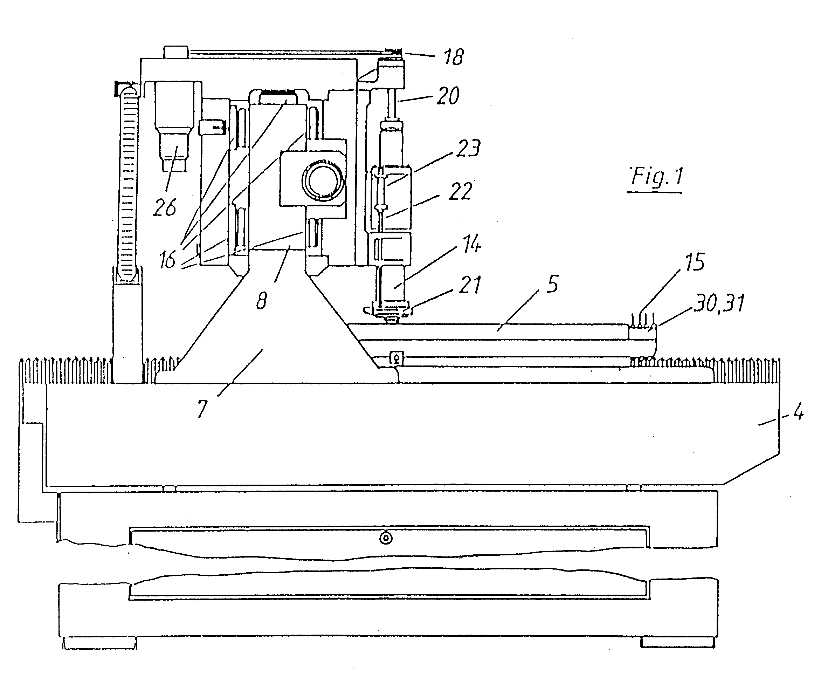

- In Fig. 1: ist eine Gesamt-Seitenansicht einer bekannten Koordinaten-Bohrmaschine gezeigt, auf der das erfindungsgemäße Verfahren durchgeführt werden kann.
- Fig. 2: ist eine Vorderansicht der gleichen Koordinaten-Bohrmaschine;
- Fig. 3: ist ein Teilausschnitt aus Fig. 2 in vergrößerter Darstellung, teilweise im Schnitt, und zwar im Augenblick des Heranfahrens der Bohrspindeleinheit auf die Spannstation der Werkzeugwechselvorrichtung; die Spannstation mit der darin vorgesehenen Spannzange kann um ein beträchtliches Maß geöffnet werden, um auch solche Werkzeuge aufnehmen zu können, deren Werkzeugdurchmesser größer ist (bis zu 6,5 mm) als deren Einspannschaft, der in der Regel einen Durchmesser von etwa 3 mm ober 1/8 Zoll hat.

Auf einem Grundgestell 2, welches die computergestützte elektronische Steuerung für die Koordinaten-Bohrmaschine enthalten kann, ist eine Granit-Grundplatte 4 vorgesehen, die das Bett für die in Richtung der Y-Achse verschiebliche Werkstückspannplatte 5 darstellt, die über Luftlager 6 auf der Oberfläche der Granit-Grundplatte 4 abgestützt ist. Auf der Grundplatte 4 stützt sich im übrigen über entsprechende Seitenteile 7 auch noch eine brückenartige Traverse 8 für den Traversenschlitten 10 ab, der sich mit Hilfe des X-Achsenantriebes 12 quer zu der Verschieberichtung der Werkstückspannplatte 5 verstellen läßt. Der Traversenschlitten 10 trägt eine Bohrspindeleinheit 14, d.h. den Antrieb und die Lagerung für die in die Bohrspindel 14 integrierte Spannzange (bei 24) zur Aufnahme der eigentlichen Bohr- oder Fräswerkzeuge 15. Der Traversenschlitten 10 ist wiederum über geeignete Axialluftlager 16 gegenüber der Traverse 8 extrem reibungsarm verschieblich. Die Bohrspindeleinheit 14 ist insgesamt in vertikaler Richtung, d.h. in Richtung der Z-Achse verstellbar, um die Bohrtiefenverstellung und andere, im Rahmen des Werkzeugwechsels notwendige Bewegungen durchzuführen. Die Bohrspindeleinheit 14 ist ein im Handel erhältliches, fertiges Bauteil, das eine zylinderische Gestalt von nicht unerheblicher radialer Ausdehnung aufweist. Die Z-Achsenverstellung der Bohrspindeleinheit erfolgt über einen entsprechenden Antrieb 26, der über einen Riementrieb 18 eine Vorschubspindel 20 verdreht, die letztlich die Axialverstellung der Bohrspindeleinheit 14 bewirkt.

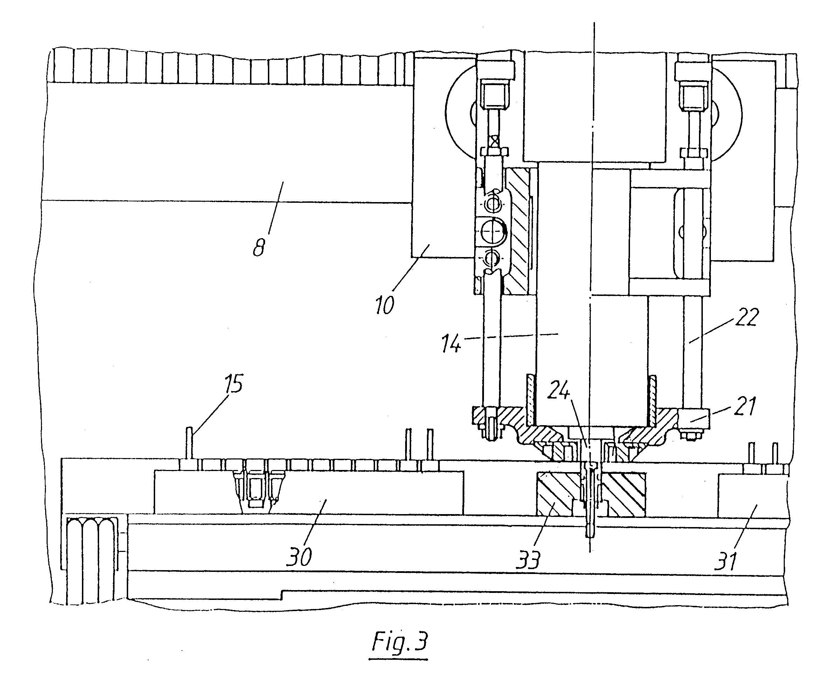

Aus Fig. 3 geht hervor, daß der der Bohrspindeleinheit 14 zugeordnete Niederhalter 21 von Führungsstangen 22 gehalten wird, die über Druckluftzylinder 23 mit der Bohrspindeleinheit 14 verbunden sind.

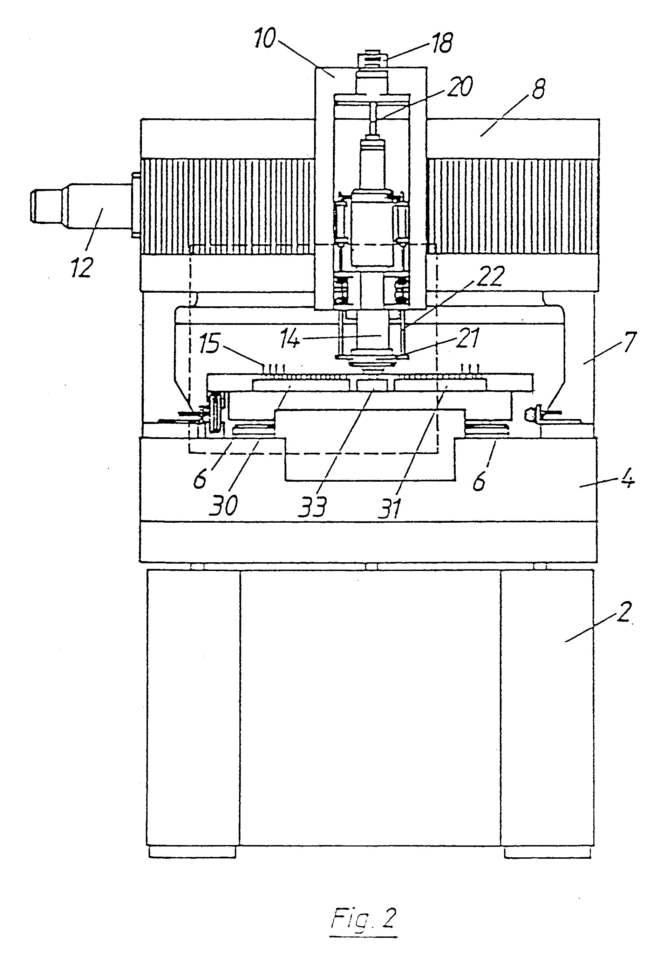

Am Rand der Werkstückspannplatte 5, d.h. im dargestellten Ausführungsbeispiel an dem der Bedienungsperson zugewandten stirnseitigen Ende in der Fig. 2 ist mindestens ein Werkzeugmagazin 30 vorgesehen, das beispielsweise in vier 12-Reihen insgesamt 48 Werkzeuge aufnimmt. Vorzugsweise kann mindestens ein weiteres Werkzeugmagazin 31 am vorderen Rand der Werkstückspannplatte 5 vorgesehen sein.

Wie aus der Fig. 3 ersichtlich ist, ragen die in dem Magazin 30 bzw. 31 gespeicherten Bohrwerkzeuge 15 mit ihrem Einspannschaft nach oben aus dem Magazin heraus, so daß die Bohrspindeleinheit 14 mit ihrer Spannzange (bei 24) bei einer entsprechenden Verstellung in X- bzw. Y-Richtung mit einem ausgewählten Werkzeug in einem der Magazine 30 oder 31 fluchtet und durch eine Zustellung in Z-Richtung das ausgewählte Werkzeug im Magazin vorläufig, d.h. am Anfang des Einspannschaftes ergreift und durch ein Zurückfahren in Z-Richtung aus dem Magazin heraushebt. Ein vollständiges Ergreifen und Einspannen des Werkzeugschaftes ist an dieser Stelle bzw. zu diesem Zeitpunkt wegen des Niederhalters 21 an der Bohrspindel 14 und wegen der dichten Anordnung der Werkzeuge im Magazin 30 nicht möglich.

Nach dem Herausziehen des vorläufig ergriffenen, ausgewählten Werkzeuges aus dem Speicherplatz im Magazin wird die Bohrspindeleinheit 14 mit dem daran befindlichen, vorläufig gehaltenen Werkzeug derart in X- und Y-Richtung verstellt, daß die Bohrspindel bzw. deren Spannzange axial mit der Spannstation 33 fluchtet, deren nähere Umgebung von Magazinplätzen freigehalten ist, um den ringlosen Einspannschaft des ausgewählten Werkzeuges, das zunächst nur am obersten Ende des Halteschafts vorläufig von der Spannzange der Bohrspindel festgehalten wird, vollends in die Spannzange 24 der Bohrspindeleinheit 14 einzudrücken. Zu diesem Zweck wird die Bohrspindeleinheit in Richtung auf die mit einer Meßschranke, z.B. mit einer Lichtschranke versehene Spannstation 33 so vertikal verstellt, bis die Spitze des Werkzeuges die Meßschranke oder einen vorgegebenen Abstand dahinter erreicht. Zu diesem Zeitpunkt ergreift die Spannzange der Spannstation das ringlose Werkzeug und hält es in dieser axialen Vorschubstellung vorläufig fest, wobei die Spannzange der Bohrspindel gelöst und danach die Bohrspindel bzw. deren Spannzange um einen vorbestimmten Betrag in Z-Richtung relativ zu dem festgehaltenen Werkzeug vorgeschoben wird. Anschließend wird das Werkzeug wieder durch die Spannzange der Bohrspindel eingespannt, d.h. an seinem Halteschaft ergriffen bzw. festgespannt. Zugleich wird die Spannzange der Spannstation wieder gelöst, wonach das Werkzeug aus der Spannstation herausgezogen wird, in der das ringlose Werkzeug also mit einem vorbestimmten Abstand der Werkzeugspitze von der Spannzange der Bohrspindel eingespannt wurde. Damit kann die LP-Bohrmaschine auch ohne die herkömmlichen Klemmringe am Werkzeugschaft stets eine vorgegebene Bohrlochtiefe genau einhalten, nachdem die Steuerung der LP-Bohrmaschine durch das erfindungsgemäße Verfahren über die genaue Lage der Werkzeugspitze auf der Z-Achse des Bohrspindelantriebes informiert ist.

## Patentansprüche

1. Verfahren zum Einspannen des Bohr- oder Fräswerkzeuges einer Leiterplatten-Bohrmaschine mit einer definierten freien Werkzeuglänge in der mit einer Spannzange versehenen Bohrspindel der Maschine,
- bei dem die Bohrwerkzeuge in einem Magazin an der Leiterplatten-Bohrmaschine achsparallel zueinander und zur Bohrspindel bereitgestellt werden,
- bei dem die leere Spannzange der Bohrspindel über ein ausgewähltes Werkzeug im Werkzeugmagazin einfährt und das Werkzeug zunächst vorläufig im Bereich des ihr zugewandten Endes am Halteschaft ergreift und aus dem Werkzeugmagazin herauszieht,
- bei dem die Spannzange der Bohrspindel mit dem vorläufig ergriffenen Werkzeug über eine Spannstation in der Nähe des Werkzeugmagazins einfährt und dort axial in Richtung auf die Spannstation zufährt bis zum Erreichen einer definierten freien Bohrerlänge, bei der das Werkzeug in der Spannzange der Bohrspindel fertiggespannt wird,
dadurch gekennzeichnet, daß
- zum Einspannen eines ringlosen Bohr- oder Fräswerkzeuges mit der definierten freien Werkzeuglänge in der Spannzange der Bohrspindel die Spannzange mit dem vorläufig ergriffenen Halteschaft des Bohrwerkzeuges in Richtung auf eine in der Spannstation vorgesehene Meßschranke vorgeschoben wird, bis die Spitze des Werkzeuges einen vorgegebenen Abstand größer/gleich Null hinter der Meßschranke erreicht, wobei die Spannzange der Spannstation gespannt und die Spannzange der Bohrspindel gelöst wird, wonach die Spannzange der Bohrspindel nachgeschoben wird, bis die gewünschte freie Werkzeuglänge erreicht ist, worauf die Spannzange der Bohrspindel fertiggespannt und zugleich die Spannzange der Spannstation wieder gelöst und das Werkzeug danach von der Bohrspindel aus der Spannstation herausgezogen wird.

2. Verfahren nach Anspruch 1, dadurch gekennzeichnet, daß der Vorschub der Bohrspindel kurzfristig unterbrochen wird, sobald die Spitze des Werkzeuges den vorgegebenen Abstand hinter der Meßschranke erreicht hat, um Zeit für das Spannen der Spannzange der Spannstation und das Lösen der Spannzange der Bohrspindel zu gewinnen.

3. Verfahren nach Anspruch 1 oder 2, dadurch gekennzeichnet, daß die Bohrspindel mit dem fertiggespannten Werkzeug zunächst aus dem Meßschrankenbereich herausfährt und anschließend nochmals einwärts durch die Meßschranke fährt zur Bestimmung des tatsächlichen Ist-Wertes der freien Bohrwerkzeuglänge.

4. Verfahren nach Anspruch 3, dadurch gekennzeichnet, daß bei einer Abweichung des Ist-Wertes der freien Werkzeuglänge vom Soll-Wert um mehr als einen vorgegebenen Wert (dL) das erfindungsgemäße Verfahren wiederholt wird.

5. Verfahren nach Anspruch 3, dadurch gekennzeichnet, daß bei einer meßbaren Abweichung des Ist-Wertes der freien Werkzeuglänge vom Soll-Wert um weniger als einen vorgegebenen Wert (dL) eine Korrekturrechnung zur Bestimmung des Bohrspindel-Vorschubes beim Bohren der Leiterplatte durchgeführt wird.

## Claims

1. Process for clamping the drilling or milling tool of a circuit board drilling machine with a defined free tool length in the drilling spindle, of the machine, which is provided with a collet:
- in which the drilling tools are prepared in a magazine on the circuit board drilling machine such that they are axially parallel to each other and to the drilling spindle;
- in which the empty collet of the drilling spindle moves in over a selected tool in the tool magazine and initially grasps the tool temporarily in the area of its end facing the collet at the holding shaft and pulls it out of the tool magazine; and
- in which the collet of the drilling spindle moves with the temporarily grasped tool via a clamping station in the vicinity of the tool magazine and there moves axially in the direction towards the clamping station until it reaches a defined free drill length at which the tool is clamped ready in the collet of the drilling spindle;
characterized in that in order to clamp a ringless drilling or milling tool with the defined free tool length in the collet of the drilling spindle the collet is advanced with the temporarily grasped holding shaft of the drilling tool in the direction of a test barrier provided in the clamping station until the tip of the tool reaches a predetermined distance which is greater than or equal to zero behind the test barrier, the collet of the clamping station being clamped and the collet of the drilling spindle being released, after which the collet of the drilling spindle is pushed back until the desired free tool length is reached, whereupon the collet of the drilling spindle is clamped ready and simultaneously the collet of the clamping station is released again and the tool is then removed by the drilling spindle out of the clamping station.

2. Process according to Claim 1, characterized in that the advance of the drilling spindle is interrupted for a short time as soon as the tip of the tool has reached the predetermined distance behind the test barrier in order to gain time for the clamping of the collet of the clamping station and the releasing of the collet of the drilling spindle.

3. Process according to Claim 1 or 2, characterized in that the drilling spindle with the ready-clamped tool firstly moves out of the area of the test barrier and then moves inwards again through the test barrier in order to determine the effective actual value of the free length of the drilling tool.

4. Process according to Claim 3, characterized in that when the actual value of the free tool length differs from the nominal value by more than a predetermined value (dL), the process according to the invention is repeated.

5. Process according to Claim 3, characterized in that when the actual value of the free tool length differs measurably from the nominal value by less than a predetermined value (dL), a correction calculation for determining the drilling spindle advance when the circuit board is drilled is performed.

## Revendications

1. Procédé pour serrer l'outil de perçage ou de fraisage d'une machine de perçage pour plaquette à circuits imprimés, avec une longueur libre définie de l'outil dans la broche de perçage pourvue d'une pince de serrage dans la machine,
- dans lequel les outils de perçage sont préparés dans un magasin dans la machine de perçage en étant parallèles les uns aux autres et à la broche de perçage,
- dans lequel la pince de serrage vide de la broche de perçage est amenée au-dessus d'un outil choisi dans le magasin à outils et saisit l'outil tout d'abord provisoirement dans la région de l'extrémité de la tige de maintien qui est orientée vers ladite pince, et extrait ledit outil hors du magasin à outils,
- dans lequel la pince de serrage de la broche de perçage avec l'outil provisoirement saisi est amenée au-dessus d'une station de serrage au voisinage du magasin à outils et y déplacée axialement en direction de la station de serrage, jusqu'à atteindre une longueur de perçage libre définie, et dans lequel l'outil est finalement serré dans la pince de serrage de la broche de perçage,
caractérisé en ce que
- pour serrer un outil de perçage ou de fraisage dépourvu de bague avec une longueur libre définie pour l'outil dans la pince de serrage de la broche de perçage, la pince de serrage est déplacée avec la tige de maintien de l'outil de perçage provisoirement saisi en direction d'une barrière de mesure prévue dans la station de serrage, jusqu'à ce que la pointe de l'outil ait atteint une distance prédéterminée supérieure ou égale à zéro derrière la barrière de mesure, et la pince de serrage de la station de serrage est serrée et la pince de serrage de la broche de perçage est libérée, suite à quoi la pince de la broche de perçage est déplacée jusqu'à atteindre la longueur libre désirée pour l'outil, suite à quoi la pince de serrage de la broche de perçage est finalement serrée, et simultanément la pince de serrage de la station de serrage est à nouveau libérée et l'outil est ensuite extrait par la broche de perçage hors de la station de serrage.

2. Procédé selon la revendication 1, caractérisé en ce que l'avance de la broche de perçage est brièvement interrompue dès que la pointe de l'outil a atteint la distance prédéterminée derrière la barrière de mesure, afin de gagner du temps pour le serrage de la pince de serrage de la station de serrage et la libération de la pince de serrage de la broche du perçage.

3. Procédé selon l'une ou l'autre des revendications 1 et 2, caractérisé en ce que la broche de perçage avec l'outil finalement serré est tout d'abord extraite hors de la région de la barrière de mesure et est à nouveau déplacée encore une fois vers l'intérieur à travers la barrière de mesure afin de déterminer la valeur réelle de la longueur libre de l'outil de perçage.

4. Procédé selon la revendication 3, caractérisé en ce que dans le cas où l'écart entre la valeur réelle de la longueur libre de l'outil et la valeur de consigne dépasse une valeur prédéterminée (dL), on répète le procédé de l'invention.

5. Procédé selon la revendication 3, caractérisé en ce que dans le cas où un écart mesurable de la valeur réelle de la longueur libre de l'outil par rapport à la valeur de consigne est inférieur à une valeur prédéterminée (dL), on procède à un calcul de correction afin de déterminer l'avance de la broche de perçage lors du perçage de la plaque à circuits imprimés.
